(19) Europäisches Patentamt
European Patent Office
Office européen des brevets

(11) Publication number: **0 433 081 A2**

# (12) EUROPEAN PATENT APPLICATION

(21) Application number: **90313647.1**

(51) Int. Cl.[5]: **G03F 7/038**

(22) Date of filing: **14.12.90**

(30) Priority: **15.12.89 JP 325788/89**

(43) Date of publication of application:
**19.06.91 Bulletin 91/25**

(84) Designated Contracting States:
**AT BE CH DE DK ES FR GB GR IT LI LU NL SE**

(71) Applicant: **W.R. Grace & Co.-Conn.**
**1114 Avenue of the Americas**
**New York New York 10036(US)**

(72) Inventor: **Nishikawa, Katsue**
**2-4-29-302 Shimotsuruma, Daiwa-Shi**
**Kanagawa-Ken, Atsugi(JP)**
Inventor: **Tsai, Hsi-Chuan**
**Royal Heights Koshi A-102, 136 Tomuro**
**Atsugi-Shi, Atsugi(JP)**

(74) Representative: **Bentham, Stephen et al**
**J.A. Kemp & Co. 14 South Square Gray's Inn**
**London, WC1R 5LX(GB)**

## (54) Photosensitive resin composition and method of use thereof.

(57) A one-component epoxy containing photosensitive composition and a method of using that composition is disclosed. The composition is aqueous developable and suitable for use as a solder, etch or plate resist in the manufacture of printed circuit boards. The composition also shows good storage stability properties and can be processed under standard exposure and development processes. The photosensitive composition primarily contains (a) at least one compound having one or more carboxyl groups, (b) at least one compound having two or more ethylenically unsaturated functionalities and (c) at least one compound having two or more epoxyl groups.

EP 0 433 081 A2

## PHOTOSENSITIVE RESIN COMPOSITION AND METHOD OF USE THEREOF

This invention relates generally to photosensitive resin compositions and particularly those compositions which function as protective photoresist films used to form and protect circuit traces during etching, plating or soldering processes performed during the fabrication of printed circuit boards.

Various kinds of resists are used in the fabrication process of printed circuit boards. They include etching, plating and solder resists. In the past, conventional screen printing techniques have been used to apply those resists to the circuit board substrates being processed. However, due to the increased integration of semiconductors, and thus increased density of printed circuit boards, resist patterns are now increasingly being prepared with photosensitive compositions. Such resists are then processed by image-wise exposure to UV radiation and post-development of the unexposed resist. However, the latter development process, which is essential for formation of the resist pattern, employs organic solvents, particularly chlorinated solvents containing 1,1,1-trichloroethane as its major component. As is well know, those chlorinated organic solvents have caused environmental pollution, toxicity and cost concerns. As a result of those concerns, their use has been restricted in recent years and more benign, less expensive aqueous developable resists have been developed for each kind of the above-mentioned resists.

Polyethyleneglycol acrylate is one known aqueous developable resist. However, because of its solubility in water, it has a high hygroscopicity and can not endure etching or plating processes. It also has particularly low electric insulation properties and humidity resistance when it is used as a permanent protective film, e.g. a solder mask. As a result of the above, it is a common practice to saponify the acrylate with alkali and thus make the above-mentioned acrylate water soluble by introducing carboxyl groups into the resin composition. For example, as disclosed in Japanese Kokai Patent SHO 60-214354 (1985), compositions comprising copolymers of an acrylic monomer and an acrylic monomer having carboxyl groups as the binder polymer have been commonly used as a resist, e.g. dry film resists. However, acrylic copolymers tend to be thermo- or photodegradable and thus tend to degrade when used in the image-forming process. Further, because a sufficient number of carboxyl groups are present on such copolymers, etching resists which use such copolymers can not endure alkaline etchants. Likewise, plating resists which use those copolymers can not endure alkaline plating baths. Even with saponification, solder resists comprising such copolymers still tend to have reduced properties such as lower surface and volume resistance and dielectric coefficients, as well as lower moisture resistance.

One attempt to solve the carboxyl group problem is to convert the carboxyl groups which remain after development into a functional group which does not detrimentally affect the cured product. For instance, as shown in Japanese Kokai Patent SHO 61-243869 (1986), Japanese Kokai Patent SHO 63-258975, and Japanese Kokai Patent HEI 1-141904 (1989), the carboxyl group is reacted with an epoxyl group of an epoxyl resin. To obtain this reaction, a catalyst, such as an amine derivative or imidazole derivative, and heat treatment is required. However, when such catalysts are in the presence of the carboxyl group and epoxyl group, reaction occurs during storage of the composition and significantly lowers the storage stability thereof. As a result, such systems are used as a two-component system with one component containing the curing catalyst and the carboxyl group containing compound and the second component containing the epoxy compound. The components are mixed together immediately before use. Nevertheless, although storage stability is not a problem when using such systems, they require more time and work for mixing, and any unused mixture has to be discarded. Other problems include irregularities in the film formed by such resist compositions wherein the irregularities are caused by air bubbles created during mixing. Such resists also experience increased formation of pinholes in the protective film.

It is a goal of this invention to solve the problems described above, and to provide a novel single component photosensitive resin composition which can be photoimaged and developed with aqueous alkaline solution, wherein the composition does not require extensive mixing, has good storage stability, and upon being cured performs as a protective resist film.

It is a goal of this invention to provide a novel resist composition possessing the above-mentioned properties wherein the composition comprises

(a) at least one compound having one or more carboxyl groups,
(b) at least one compound having two or more ethylenically unsaturated functionalities,
(c) at least one compound having two or more epoxyl groups,
(d) a latent epoxyl curing agent, and
(e) a photopolymerization initiator.

It is a further goal to provide a new method of preparing a resist pattern suitable for preparing circuit boards, wherein the method comprises

(i) applying to a circuit board substrate a photosensitive resin composition comprising

(a) at least one compound having one or more carboxyl groups;

(b) at least one compound having two or more ethylenically unsaturated functionalities;

(c) at least one compound having two or more epoxyl groups;

(d) a latent epoxyl curing catalyst, and

(e) a photopolymerization initiator; and

(ii) exposing the coated substrate in (i) to actinic radiation in an imagewise fashion;

(iii) developing the unexposed areas of the coating in (ii) in an aqueous based solution so that the coating forms a resist pattern; and

(iv) optionally heating or exposing to actinic radiation, the resist pattern in (ii) to further cure said pattern.

To form the above-mentioned photosensitive composition, the components (a)-(e) are formulated under well known conditions.

Examples of the carboxyl group-containing compound (a) include, but are not limited to, polymers of carboxylic acid derivatives having unsaturated groups, such as acrylic acid, methacrylic acid, cinnamic acid, crotonic acid, itaconic acid, maleic acid, fumaric acid, aconitic acid, hymic acid and the like. Copolymers containing two or more of these monomers, or the esters, e.g. (meth)acrylates, of those acids are also suitable. The polymers can be used alone or as a mixture with other carboxylated polymers.

Other examples of the carboxyl group-containing compounds include those compounds which are the reaction products of acid anhydride and polymeric compounds having active hydrogens. Examples of the active hydrogen-containing compounds include, but are not limited to, phenoxy resins, phenol resins, Novolak resins, resol resins, poly-p-vinylphenols, polyvinyl alcohols, and their partially acetalized products, polyamines, e.g. polyallyl amines, and polyaniline and the like.

The ethylenically unsaturated compound (b) contains at least two ethylenically unsaturated functionalities, and can be in liquid or solid form at ambient temperature and pressure. Examples of such ethylenically unsaturated compounds are (meth)acrylic acid esters, allyl compounds, vinyl ethers, vinyl esters, cinnamic acid esters and the like. specific examples of (meth)acrylic acid esters are epoxy (meth)-acrylates acquired by reaction of a carboxylic acid having ethylenically unsaturated bonds and epoxyl resins having an epoxyl functionality of two or greater. Urethane (meth)acrylates prepared by reaction of a polyvalent aromatic or aliphatic isocyanate and (meth)acrylic acid esters of polyvalent alcohols are also suitable for compound (b).

specific examples of allyl compounds are diallyl esters of phthalic acid, adipic acid and malonic acid and the like. Specific examples of vinyl ethers are the vinyl ethers of polyvalent alcohols such as glycerol, trimethylolpropane and pentaerythritol. specific examples of vinyl esters are divinyl succinate, divinyl phthalate, and divinyl adipate and the like. Polyvinyl cinnamate is a specific example of a cinnamic acid ester.

One preferred embodiment of the photosensitive composition comprises a compound that has both ethylenically unsaturated functionalities and carboxyl groups. A specific example of this preferred embodiment is a carboxylated epoxy acrylate prepared by reacting (meth)acrylic acid and a Novolak epoxy resin, wherein the resulting epoxy acrylate is then reacted with an acid anhydride through the secondary hydroxyl group in the epoxy (meth)acrylate. It is believed that by using this embodiment, it is possible to impart sufficient photosensitivity to the composition without reducing the alkali developability. Further, it is also believed that the heat resistance of the cured compound is improved as a result of using the epoxy.

Suitable examples of the acid anhydride that can be used to prepare the above-mentioned preferred embodiment include dibasic acid anhydrides such as maleic anhydride, succinic anhydride, phthalic anhydride, tetrahydrophthalic anhydride, anhydrous methylhexahydtrophthalic acid, *endo*-methylene tetrahydrophthalic anhydride, and anhydrous chlorendoic acid and the like. Other suitable anhydrides are aromatic polyvalent carboxylic anhydrides such as trimellitic anhydride, pyromellitic anhydride and anhydrous benzophenone tetracarboxylic acid and the like, and anhydrous derivatives of such polyvalent carboxylic acids. Itaconic anhydride and 5-norbornene-2,3-dicarboxylic anhydride can also be used as the acid anhydride.

Suitable compounds having at least two epoxyl groups, i.e. compound (c), include glycidyl ether type epoxyl resins such as bisphenol A epoxyl resins, glycidyl esters of polyvalent carboxylic acids, glycidylamine type epoxyl resins, linear aliphatic epoxyl resins, alicyclic epoxyl resins, novolak epoxyl resins and the like. In order to improve the heat resistance of the cured product, it is preferable to use epoxyl resins that have an aromatic ring and have three or more epoxyl groups. It is also preferable to add the epoxyl resin in such an amount that the molar equivalency ratio of the epoxyl group, based on the equivalency of the carboxyl group in the composition, will be 0.8 - 3.0, and preferably 1.0 - 2.0. If the ratio is lower than 0.8, a sufficient number of carboxyl groups may remain in the cured product so that deficient

properties of the cured product may result. On the other hand, if the ratio exceeds 3.0, a sufficient number of carboxyl groups may not be present so that it will be difficult to develop the composition in an aqueous alkaline solution. Suitable epoxy compounds for (c) include Epicoat® epoxies from Shell, Der® epoxies from Dow Chemical and YDCN-638P epoxy from Toto Kasei K.K.

The epoxy curing catalyst (d) used in the composition is a latent curing catalyst. The term "latent" is used to define a curing agent on which the active functional group responsible for initiating the curing is physically or chemically blocked, but which will be exposed upon, for example, application of pressure or heating. Examples of curing catalysts with physically concealed active functional groups are known epoxy curing agents which have been encapsulated in molecular sieves. The sieves will release the catalyst upon mechanical force, humidity or heating. Other physical barriers to the catalyst include microcapsules which encapsulate the active curing catalyst as tiny droplets at room temperature but can be activated by destroying the capsules upon heating or by application of pressure.

Suitable examples of curing catalysts on which functionality groups are chemically blocked are amine imides represented by the general formula (1) and N-(4-chlorophenyl)-N,N-dimethyl urea represented by general formula (2), both (1) and (2) illustrated below.

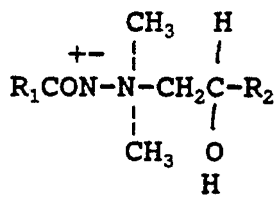

(1)

wherein $R_1$ is $-CH_3$, $-C_2H_5$, 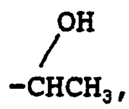, $-C_4H_9$, and

$R_2$ is $-CH_3$.

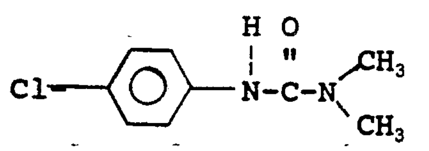

(2)

A preferred amine imide is N,N-dimethyl-N-(2-hydroxy-3-allyloxypropyl) amine-N'-lactimide. See Journal of Applied Polymer Science, Volume 27, pp. 2361-2368 (1982).

In another preferred embodiment, the curing catalyst is a microencapsulated powdery amine compounds treated with isocyanates. Compositions using those latent curing catalysts have a high storage stability at room temperature and the curing reaction can proceed at a relatively low temperature in a short period of time. Details of these catalysts are described in Japanese Kokai Patent SHO 64-70523 (1989) or in Coating Jiho, No. 183, page 1 (1989).

Other examples of the latent curing catalyst are those compounds having a low solubility in the composition while under ambient conditions, or those compounds whose solubility at ambient conditions has been reduced by special reactions. To induce curing with those type of catalysts, heat is applied to the composition. These catalysts are available as Novacure® curing agents from Asahi Kasei K.K. and Ajicure® curing agents from Ajinomoto K.K.

Suitable examples of the photopolymerization initiators (e) are those which form free radicals upon irradiation with actinic radiation. Such initiators include quinones such as 2-ethyl-anthraquinone, 2-t-butyl-anthraquinone, octamethyl-anthraquinone, and 1,2-benz-anthraquinone; benzoin, pivaloin, α-ketaldonyl alcohols and ethers such as acyloin ether; ketones such as α,α'-diethoxyacetophenone, benzophenone, a-phenylbenzoin, 4,4'-bisdialkylamino benzophenone and the like; and 2,4,5-triaryl imidazolyl dimer and the like. The initiators above can be used alone or as a mixture of two or more such compounds.

Acrylic monomers and oligomers, and their esters, which are liquids at room temperature and have at least one ethylenically unsaturated group can be added to the final composition of (a)-(e) as a diluent. Organic solvents such as methylethyl ketone, cyclohexanone, toluene, xylene, cellosolve, carbitol, cellosolve

acetate and carbitol acetate can also be used as a diluent.

Additional additives such as coloring agents, thermal polymerization inhibitors, leveling agents, adhesion promoters, thixotropic agents, filler, and the like can be used as needed.

Once formulated the composition is coated onto the desired substrate, is exposed preferably to ultraviolet radiation, and is developed using well known aqueous development procedures. For example, a liquid resin composition may be coated directly onto the substrate by means of a roll coater, spin coater, doctor knife, wire bar, or sprayer, etc. Alternatively, the composition may be coated first onto a suitable supporting member, such as a transparent polyethylene terephthalate film, to form a film-like material which is then pressed against the substrate to form a resin layer on the substrate. The coated substrate is then irradiated with actinic radiation using a light source such as high pressure mercury lamp, ultra high pressure mercury lamp, or metal halide lamp, etc. The substrate is irradiated in an imagewise fashion through a negative mask.

After exposure, an aqueous solution of inorganic alkali, such as sodium hydroxide, potassium hydroxide, sodium carbonate, or the like; ammonia; or organic alkali, such as tetramethyl ammonium bromide or tetramethylammonium hydroxide, is sprayed onto the substrate to develop the exposed image. The resulting resist pattern is then cured by heat treatment. However, prior to heat treatment, the patten may be further irradiated with actinic radiation if needed.

As a result of using the combination of the above compounds, a suitable photosensitive composition having acceptable properties is prepared. The composition is radiation curable as a result of using ethylenically unsaturated compound (b), and thus allows for easy application onto circuit boards designed for high density units. carboxylated compound (a) allows for the composition to be water developable while the epoxy compound (c) results in better curability. The use of the latent curing agent allows the composition to be an effective one component system without sacrificing storage stability. For instance as Table I illustrates, storage stability of more than three months at room temperature under environmentally shielded conditions was obtained. Finally, and more importantly, the resulting protective film possesses the necessary properties for a resist to etching, plating and soldering work.

In order to further illustrate the practice of the present invention and the advantages thereof, the following examples are provided. However, these examples are in no way meant to be limitative, but merely illustrative. All parts indicated are parts by weight.

Example 1

(1) Synthesis of acrylic copolymers having carboxyl groups:

100 g acrylic acid, 60 g methacrylic acid, 35 g methylacrylate, and 5 g acrylamide in 250 g isopropyl alcohol were added to a 100 ml four-necked flask equipped with gas inlet port, stirrer, condenser, and thermometer, and were mixed under a nitrogen blanket. After raising the temperature to 80° C, 2 g azobisisobutyronitrile in 50 g isopropyl alcohol was added to the flask. The resulting polymerization reaction was run for 5 hours to obtain a solution containing 40 weight % of an acrylic copolymer having carboxyl groups.

(2) Synthesis of novolak epoxyl acrylates:

After dissolving 206 g cresol novolak epoxyl resin (1.0 equivalent) (epoxyl equivalent = 206)YDCN-701P from Toto Kasei K.K. in 276 g cellosolve acetate, 2.8 g triethylamine catalyst and 1 g p-methoxy phenol (0.35%) thermal polymerization inhibitor were added. The temperature was then raised to 100° C, whereupon 70 g acrylic acid (0.97 equivalent) was added dropwise over a 30 minute period. Then, the reaction temperature was raised to 120° C whereupon further reaction was carried out for 3 hours to obtain a cellosolve acetate solution containing 50% cresol novolak epoxyl acrylate.

(3) Synthesis of bisphenol A epoxyl acrylate:

380 g Epicoat 828 bisphenol A epoxyl resin (epoxyl equivalent = 190) (2.0 equivalent) from Yuka Shell K.K.and 140 g acrylic acid (1.9 equivalent) were dissolved in a 1000 ml four-necked flask. Then 5 g 2-methyl-4-ethyl imidazole catalyst (1%) and 1.8 g p-methoxyphenol (0.35%) inhibitor were added, with a subsequent reaction run at 95° C for 5 hours to obtain a bisphenol A epoxyl acrylate.

(4) Preparation of Photosensitive Resin Composition:

A photosensitive resin composition was prepared from the following component parts by weight:

| | |
|---|---|
| Acrylic copolymer from (1) | 55 parts |
| Novolak epoxyl acrylate from (2) | 32 parts |
| Bisphenol A epoxyl acrylate from (3) | 5.5 parts |
| Trimethylolpropane triacrylate | 5.5 parts |
| 2-Methyl-1-[4-(methylthio)phenyl]-2-morpholinopropane-1 (available as Irgacure 907 from Ciba-Geigy Co.) | 4.5 parts |
| Phthalocyanin Green | 1.6 part |
| Hydroquinone | 0.2 part |
| Tetraglycidyldiaminodiphenylmethane available as Epicoat 604 from Yuka Shell K.K. | 42 parts |
| Amine imide, i.e. N,N-dimethyl-N-(2-hydroxy-3-allyloxy-propyl)amine-N'-lactimide | 2.7 parts |

(5) Formation of Resist Film Pattern:

After coating the above-described resin solution from (4) onto a polyethylene terephthalate film (thickness = 25 µm) so that the thickness of the resin after drying would be 30 µm, the resin was dried at room temperature for 20 minutes, at 50° C for 10 minutes, at 80° C for 10 minutes, and at 100° C for 5 minutes. The resulting film was thermally pressed by conventional lamination techniques onto a glass/epoxy circuit board formed with a circuit pattern and througholes. The film was then irradiated with ultraviolet light (300 $mJ/cm^2$) through a negative mask. After the polyethylene terephthalate film was peeled off from the film, the film was sprayed with a 1.5 weight % sodium carbonate solution to develop the unexposed areas of the film. After thoroughly washing with water and drying, the film was heated at 150° C for 30 minutes to obtain a solder protective film (mask) pattern. Using this protective film, a test for resistance to solder heat by floating the board for 10 seconds on a 260° C soldering bath was run for 3 cycles. No evidence of a thermal breakdown, i.e. any crack or separation in the protective film, was observed. Further testing for more than three months at room temperature under an environment shielded from light did not detrimentally affect the composition's resist properties.

Example 2

(1) Synthesis of carboxylated novolak epoxyl acrylate:

180 g Epicoat® 154 phenol novolak epoxyl resin, (epoxy equivalent = 180) (1 equivalent) from Yuka Shell K.K. was dissolved in 150 g toluene in a 500 ml four-necked flask equipped with stirrer, thermometer, condenser, and air inlet port. 3 g triphenyl phosphine catalyst and 1.3 g hydroquinone thermal polymerization inhibitor were added. 76 g acrylic acid (1 equivalent) was added dropwise, with a subsequent reaction at 100° C to acrylize the Novolak type epoxyl resin run for 5 hours. After allowing the reaction mixture to cool down to 90° C, 74 g maleic anhydride (0.75 equivalent) in 104 g toluene was added, and additional reactions continued at 90° C for 3 hours. A 50% solution of epoxyl acrylate that has carboxyl groups was obtained.

(2) A photosensitive resin composition was prepared in a roll mill as follows:

| | |
|---|---|
| Carboxylated epoxyl acrylate from (1) | 56 parts |
| Pentaerythritol triacrylate | 7 parts |
| 1:1 addition product of phthalic anhydride and 2-hydroxyethyl acrylate | 14 parts |
| Silica powder | 1.0 part |
| Talc | 8 parts |
| 10:1 mixture of benzophenone and Michler's ketone | 3 parts |
| Phthalocyanin Green | 2 parts |
| DER® 332 bisphenol A epoxyl resin having epoxyl equivalent 194 from Dow Chemical Co. | 27 parts |
| Latent epoxyl curing catalyst (See Ex. 1 Kokai 64-70523) | 6 parts |

(3) Formation of protective film pattern:

The resin composition described in (1) of this Example was screen printed (150 mesh screen) onto a printed circuit board having throughholes. The thickness of the resulting emulsion film was 50 µm. After removing the solvent from the emulsion film by drying at 80°C for 30 minutes, the film was exposed to light and developed by the method according to (5) in Example 1 and then heated at 150°C for 30 minutes, to form a protective resist film pattern. Terminals were then gold plated and soldered onto the board. No evidence of breakdown of the protective film under or adjacent to the soldering and plating was observed. Further testing for 4 weeks in an environment of 100°C/90% RH, as described in IPC SM-840-A showed no breakdown. Storage stability of the photosensitive resin composition pursuant to this Example are shown in Table 1.

Example 3

(1) Synthesis of bisphenol A carboxylated epoxyl acrylate:

98 g bisphenol A epoxyl acrylate (molecular weight = 1950) (OH group = 0.2 equivalent) available as VR-60 from Showa Kobunshi K.K., and 113 g trimethylpropane triacrylate were placed and dissolved at 80°C in a 500 ml three-necked flask equipped with stirrer, thermometer and condenser. 14.8 g maleic anhydride (0.15 equivalent) was added, and a reaction was run at 90°C for 30 minutes to obtain a solution containing 50% bisphenol A type carboxylated epoxyl acrylate.

(2) A photosensitive composition was then prepared as follows:

| | |
|---|---|
| Epoxyl acrylate from (1) | 40 parts |
| Lipoxy® SP-4060 cresol novolak epoxyl acrylate from Showa Kobunshi K.K. | 20 parts |
| 1:1 addition product of phthalic anhydride and hydroxyethyl methacrylate | 12 parts |
| Irgacure 651 | 6 parts |
| Phthalocyanin Green | 1.6 part |
| Hydroquinone | 0.4 part |
| Phenol Novolak epoxyl resin available as YDCN-638P from Toto Kasei K.K., (epoxyl equivalent = 178) | 15 parts |
| Ajicure PN-23 latent epoxyl curing agent from Ajinomoto K.K. | 5 parts |

(3) Formation of solder protective film pattern:

The above-described photosensitive composition solution was coated onto a substrate according to the procedures in Examples 1 and 2, using a roller coater. A film thickness of 30 µm resulted. The film was then irradiated through a negative mesh with ultraviolet radiation at a distance of about 1 mm from the coated surface. The film was then developed and washed with water according to the development process described in Example 1. After being dried thoroughly, the film was further irradiated again with 2 J ultraviolet light, and then heated at 130°C for 1 hour to cure the film. Using this protective resist film, soldering work and gold plating work were carried out as described in Examples 1 and 2. The film sufficiently performed as a protective film.

Example 4

(1) Synthesis of carboxylated phenoxy resin:

100 g phenoxy resin (hydroxyl group = 0.35 equivalent/100 g) available as YP-50, from Toto Kasei K.K., in 190 g methylethylketone was added to a 1-liter three-necked flask equipped with condenser, stirrer, and thermometer. 27.5 g maleic anhydride (0.28 equivalent) in 295 g methylethyl ketone was then added, and reacted at 90°C for 5 hours. The solvent was removed by distillation, leaving a phenoxy resin having carboxyl groups.

(2) Synthesis of phenol novolak carboxylated epoxyl acrylate:

305 g phenol novolak epoxyl resin (epoxyl equivalent = 178) (1 equivalent) available as YDPN-638P from Toto Kasei K.K., 305 g trimethylolpropane triacrylate (TMPTA), 0.6 g p-methoxyphenol thermal polymerization inhibitor, and 1.6 g triphenyl phosphine catalyst were charged into a 1-liter four-necked flask equipped with stirrer, condenser and air inlet port. While blowing a stream of air into the flask, 74 g acrylic acid (1.03 equivalent) was added dropwise and reacted at 110°C for 5 hours. Then, after lowering the temperature to 90°C, 116 g anhydrous *cis*-hexahydrophthalic acid (0.75 equivalent) was added and reacted at 90°C for 5 hours, to obtain carboxylated epoxyl acrylate that contained 50% TMPTA.

(3) Preparation of photosensitive resin composition:

A photosensitive resin composition having the following composition was prepared.

| | |
|---|---|
| Phenoxy resin obtained in (1) | 2.5 parts |
| Bisphenol A epoxyl acrylate obtained in (1) of Example 3 | 15 parts |
| Novolak epoxyl acrylate obtained in (2) | 40 parts |
| Trimethylolpropane triacrylate | 16 parts |
| Phenol novolak epoxyl resin YD-693P (product of Toto Kasei K.K., epoxyl equivalent = 178) | 16 parts |
| 10:1 mixture of benzophenone and Michler's ketone | 4.5 parts |
| Microencapsulated amine epoxyl curing agent; See Example 2 of Kokai Sho 64-70523 | 6 parts |

(4) Formation of solder protective film pattern:

Using a roller coater, the photosensitive composition prepared according to (2) of this example was coated onto a printed circuit board substrate having throughoholes. The resulting film thickness was 50 µm. The film was exposed to ultraviolet light (300 mJ/cm$^2$) in an image-wise fashion at a distance of about 1 mm. Then, 1% aqueous sodium carbonate solution was sprayed on the board to develop the unexposed areas of the film. The developed film was heated and cured at 150°C to prepare the solder protective film (mask) pattern. The film was evaluated by the methods described in Example 3. The film exhibited sufficient properties to serve as a solder and gold plating mask.

Example 5

(1) A photosensitive composition was prepared as follows:

| | |
|---|---|
| Bisphenol A epoxyl acrylate prepared according to (1) in Example 3 | 35 parts |
| Novolak epoxyl acrylate prepared according to (2) in Example 4 | 35 parts |
| NK Ester A-NPG from Shin Nakamura Kagaku K.K. (neopentylglycol diacrylate) | 8 parts |
| Epicoat 1031 epoxyl resin, epoxyl equivalent = 125, from Yuka Shell K.K. | 11 parts |
| Irgacure 651 | 5 parts |
| Latent epoxyl curing agent as described in (2) of Example 1 | 6 parts |

(2) Formation of solder protective film pattern:

The photosensitive composition prepared according to (1) of this Example was coated onto a printed circuit board substrate according to the procedure described in (3) of Example 3. The film was then exposed to UV radiation, developed, and cured according to the procedures described in (3) of Example 3 to form a protective film pattern. The resulting film was used when soldering and gold-plating a substrate

according to the procedure described in Example 1. No deterioration of the film was observed.

Comparative Example 1

A photosensitive composition according to Example 2 above was prepared, except 2 parts 2-ethyl-4-methyl imidazole was used to substitute for the 6 parts latent curing agent. A protective film pattern was then formed from the modified composition by the procedure described in Example 2, and evaluated. Although there was no immediately recognized difference in the properties of this film from those shown by the film prepared in Example 2, it was no longer possible to form a film from the composition 10 hours after the composition's preparation. The viscosity of the composition had increased significantly to the point the preparation of a coating was no longer possible.

Comparative Example 2

A photosensitive composition was prepared as described in Example 3, except substituting the Ajicure curing agent with triphenyl phosphine.

Comparative Example 3

A photosensitive composition was prepared as described in Example 4, except replacing the microencapsulated curing agent with 1,8-diazabicyclo-[5,4,0]-7-undecene (DBU).

Comparative Evaluation of Storage Stability

Compositions of Comparative Examples 2 and 3 were used to prepare resist patterns according to the procedures as described in Examples 3 and 4. The effectiveness of the films as soldering and gold plating protective films was evaluated. No difference was observed between the films prepared according to the Examples and the films which were prepared immediately from the photosensitive resin composition formulated according to the Comparative Examples.

To compare the storage stability, the compositions prepared according to Examples 2-5 and Comparative Examples 1-3 were then stored in an oven at 40° C + 2° C. Samples were taken after a certain time period, i.e. 3 days, 7 days and 14 days, and cooled to 25° C. Their viscosity at 25° C was then measured using a BH type viscosimeter. The viscosity obtained after each period was divided by the initial viscosity, with the resulting ratio regarded as the 'tactifying coefficient. This coefficient was used as a measure of storage stability, with the results shown in Table 1 below. After 7 days at 40° C, the comparative examples gelled and viscosities could not be measured.

Table 1

| No. | 40°C x 3 days | 40°C x 7 days | 40°C x 14 days |
|---|---|---|---|
| Example 2 | 1.2 | 1.4 | 1.4 |
| Example 3 | 1.2 | 1.5 | 1.7 |
| Example 4 | 1.1 | 1.3 | 1.3 |
| Example 5 | 1.0 | 1.3 | 1.2 |
| Comparative Example 1 | 28.1 | --- | --- |
| Comparative Example 2 | 25.0 | --- | --- |
| Comparative Example 3 | 18.3 | --- | --- |

**Claims**

1. A single component photosensitive resin composition comprising
   (a) at least one compound having one or more carboxyl groups,
   (b) at least one compound having two or more ethylenically unsaturated functionalities,
   (c) at least one compound having two or more epoxyl groups,
   (d) a latent epoxyl curing catalyst, and
   (e) a photopolymerization initiator.

2. A resin composition according to Claim 1 wherein (a) is a copolymer of acrylic and methacrylic acid and methacrylate; (b) is a mixture of novolak and bisphenol A epoxy acrylates; and (c) is tetraglycidyl diaminodiphenyl methane.

3. A resin composition according to Claim 1 wherein (a) is a carboxylated phenoxy resin; (b) is a mixture of carboxylated bisphenol A epoxy acrylates and carboxylated phenol novalak epoxy acrylates; and (c) is phenol novolak epoxy.

4. A resin composition according to Claim 1, wherein compound (a) or compound (b) is a compound having both at least one carboxyl group and at least two ethylenically unsaturated functionalities.

5. A resin composition according to Claim 4, wherein the compound having at least one carboxyl group and at least two ethylenically unsaturated functionalities is the reaction product of a saturated or unsaturated polybasic acid with a product obtained by reacting an aromatic ring-containing epoxy compound and an unsaturated carboxylic acid.

6. A resin composition according to Claim 4 or 5 wherein (a) or (b) is a mixture of carboxylated epoxyl acrylate and an addition product of phthalic anhydride and 2-hydroxyethyl acrylate and (c) is a bisphenol A epoxy.

7. A resin composition according to Claim 4 or 5 wherein (a) or (b) is a mixture of carboxylated epoxyl acrylate and an addition product of phthalic anhydride and hydroxyethyl methacrylate; and (c) is phenol novolak epoxy.

8. A method of preparing a resist pattern suitable for preparing circuit boards, wherein the method comprises
   (i) applying to a circuit board substrate a photosensitive resin composition comprising
      (a) at least one compound having one or more carboxyl groups,
      (b) at least one compound having two or more ethylenically unsaturated functionalities,
      (c) at least one compound having two or more epoxyl groups,
      (d) a latent epoxyl curing catalyst; and
      (e) a photopolymerization initiator;
   (ii) exposing the coated substrate in (i) to actinic radiation in an imagewise fashion; and
   (iii) developing the unexposed areas of the coating in (ii) in an aqueous basic solution so that the coating forms a resist pattern.

9. A method according to Claim 8 which further comprises after step (iii):
   (iv) heating or exposing to actinic radiation, the resist pattern in (ii) to further cure said pattern.

10. A method according to Claim 8 or 9 wherein the resin composition in step (i) is as claimed in any one of Claims 2 to 7.

11. A method according to Claim 8, 9 or 10 wherein the resist is applied as a solder mask.